# EUROPÄISCHE PATENTSCHRIFT

(11) **EP 0 750 382 B1**
(45) Veröffentlichungstag und Bekanntmachung des Hinweises auf die Patenterteilung: **29.12.1999**
(21) Anmeldenummer: 96250130.0
(22) Anmeldetag: 12.06.1996
(51) Int. Cl.: H02H 7/26, H01F 38/20, G01R 15/14, H02H 7/22

(54) **Stromerfassungsgerät zur Anbringung an einem stromdurchflossenen Leiter**
Current detecting device for mounting on a current-carrying conductor
Dispositif de détection de courant pour le montage sur un conducteur parcouru par le courant

(30) Priorität: 23.06.1995 DE 19523725
(43) Veröffentlichungstag der Anmeldung: 27.12.1996
(73) Patentinhaber: SIEMENS AKTIENGESELLSCHAFT, 80333 München (DE)
(72) Erfinder: Ette, Bernd, 10119 Berlin (DE); Hochgraef, Holger, 16845 Ganzer (DE); Schiller, Manfred, Dr., 14169 Berlin (DE)

(56) Entgegenhaltungen:
- EP-A- 0 314 849
- WO-A-81/01092
- DE-A- 3 707 707
- ABB REVIEW, Nr. 2, 1.Januar 1996, CH, Seiten 18-24, XP000581728 ESCHERMANN B ET AL: "CONTINUOUS SELF-SUPERVISION ENHANCES RELIABILITY OF HV SUBSTATION PROTECTION"

## Beschreibung

Die Erfindung betrifft ein Schaltgerät mit einem Stromerfassungsgerät zur Anbringung an einem stromdurchflossenen Leiter, mit einem Stromsensor und einer eine Ausgangsgröße des Stromsensors verarbeitenden Schaltungsanordnung sowie mit einer die Schaltungsanordnung tragenden Leiterplatte und mit einem die Leiterplatte aufnehmenden Gehäuse, das eine Öffnung für den Durchtritt des Leiters besitzt, wobei die Schaltungsanordnung eine Mikroprozessorschaltung zur Bereitstellung durch Vergleich gemessener Stromwerte mit vorgegebenen Parametern ermittelter Ausgangswerte sowie eine Schalteinrichtung zur Abgabe eines Auslösesignales für das Schaltgerät besitzt.

Ein Schaltgerät mit einem Stromerfassungsgerät der genannten Art ist z. B. durch die WO 81/01092 bekannt geworden. Das Stromerfassungsgerät enthält nach Bedarf als Ruhe- oder Arbeitskontakte ausgebildete Schaltkontakte als Signalgeber zur Steuerung des Schaltgerätes. Damit kann beispielsweise die Magnetspule eines Schützes unmittelbar betätigt werden.

Ein Stromerfassungsgerät der vorstehend erwähnten bekannten Art nimmt die Funktion eines Auslösers war. Für mehrpolige Schaltgeräte einer Baugröße, welche die Abmessungen üblicher Schütze und Motorschutzschalter wesentlich überschreitet, ist demgegenüber eine verteilte Anordnung der Komponenten der Schutzeinrichtungen gebräuchlich. Daher befinden sich die Stromwandler bzw. Stromsensoren an den rückseitigen Anschlußschienen des Schaltgerätes und sind durch Verbindungsleitungen innerhalb des Schaltgerätes mit einem gemeinsamen elektronischen Auslöser verbunden, der die Stromsignale aller Stromwandler bzw. Stromsensoren auswertet und durch Abgabe eines Auslösesignales den Schaltmechanismus des Schaltgerates freigibt. Dies kann z.B. durch einen Auslösemagnet geschehen, der eine Verklinkung innerhalb des Schaltmechanismus freigibt.

Der Erfindung liegt die Aufgabe zugrunde, die in Verbindung mit den Schutzeinrichtungen stehende Geräteanordnung zu vereinfachen und eine höhere Sicherheit gegen Störungen zu erreichen.

Gemäß der Erfindung wird diese Aufgabe dadurch gelöst, daß bei einem mehrpoligen Schaltgerät jedem der Pole ein Stromerfassungsgerät zugeordnet ist und daß das Stromerfassungsgerät eine Busschnittstelle zur Übertragung der Auslösesignale in einem zugehörigen Bussystem aufweist, wobei das Bussystem das Stromerfassungsgerät und einen Schaltmechanismus des Schaltgerätes miteinander verbindet. Hierdurch wird erreicht, daß der bisher erforderliche, für mehrere Pole eines Schaltgerätes gemeinsame Auslöser nicht mehr benötigt wird. Die Stromerfassungsgeräte üben vielmehr selbst die Aufgaben eines Auslösers aus. Durch diesen Umstand in Verbindung mit dem Bussysten innerhalb des Schaltgerätes wird auch die Störsicherheit verbessert, weil aufgrund der unmittelbaren räumlichen Nähe zwischen dem Stromsensor und der zugehörigen Schaltungsanordnung störende Einstreuungen aus dem Hauptstromkreis eines Schaltgerätes sich nicht auswirken bzw. der Einfluß solcher Einstreuungen durch örtlich wirkende Abschirmungen ausgeschlossen werden kann. Damit ist auch die Möglichkeit geschaffen, Stromsensoren mit sehr kleiner Ausgangsgröße, insbesondere Rogowski-Spulen mit verhältnismäßig geringer Windungszahl, vorteilhaft einzusetzen.

Dabei dient das Bussystem nicht nur als Mittel zur Signalübertragung zur Steuerung des Schaltmechanismus z.B. mit; tels eines Auslösemagneten, vielmehr können zugleich aus dem Bussystem alle wesentlichen Größen ausgelesen und zur Anzeige gebracht werden, die im Betrieb der Stromerfassungsgeräte anfallen. Hierzu gehören in bekannter Weise die in den einzelnen Polen eines Schaltgerätes fließenden Ströme, Anzeige einer bevorstehenden Auslösung und ähnliche Angaben. Das Schaltgerät kann ein Leistungsschalter oder eine Gerätekombination sein, wie sie in der Gestalt von Einschüben zur Steuerung von Verbrauchern gebräuchlich sind.

Mikroprozessoren weisen interne Bussysteme auf, welche die Funktionsgruppen des Mikroprozessors miteinander verbinden (DE-Fachbuch "Lexikon der Elektronik", Braunschweig/Wiesbaden 1983, Seite 313). Hiervon zu unterscheiden sind solche Bussysteme, die eine größere räumliche Ausdehnung haben und die installiert werden, um komplexe Anlagen zu steuern (vgl. die genannte Literaturstelle, Seite 64). Im vorliegenden Zusammenhang ist unter "Bussystem" ein solches räumlich ausgedehntes System zu verstehen, das sich innerhalb eines Schaltgerätes zwischen den Stromerfassungsgeräten und dem Schaltmechanismus erstreckt und somit mehrere Mikroprozessoren und wenigstens ein peripheres Gerät miteinander verknüpft.

Das Vorhandensein einer Mikroprozessorschaltung in jedem Stromerfassungsgerät bietet die vorteilhafte Möglichkeit, weitere Überwachungen bzw. Messungen durchzuführen, die sich auf den mit dem Stromerfassungsgerät verknüpften Leiter beziehen. Hierzu kann insbesondere im Bereich der Öffnung des Gehäuses ein Kontaktelement mit dem Leiter elektrisch verbunden sein, während auf der Leiterplatte eine Schaltungsanordnung zur Messung der Spannung des Leiters angeordnet ist. Damit ist die Möglichkeit geschaffen, über das Bussystem auch der Spannung jedes Leiters entsprechende Signale zu übertragen und an geeigneter Stelle zur Anzeige zu bringen. Ferner besteht die Möglichkeit, einen zwischen dem Strom und der jeweils gemessenen Spannung bestehenden Phasenwinkel zur Bestimmung des cos ϕ auszuwerten und im Bedarfsfall in bekannter Weise die Leistung zu berechnen.

Das vorstehend erwähnte Kontaktelement kann gut wärmeleitend ausgebildet sein und kann mit einem Temperatursensor in Verbindung stehen. Damit kann über das Bussystem auch ein Signal für die Temperatur in jedem Pol eines Schaltgerätes übertragen und zur Anzeige gebracht werden. Gleichfalls ist ein solches Stromerfassungsgerät zur Überwachung von Sammelschienen gut geeignet.

In Schaltanlagen sind oftmals mehrere Schaltgeräte (Leistungsschalter, Schaltgerätekombinationen) sowie Sammelschienen vorhanden. Dementsprechend gibt es eine Vielzahl von Meßstellen, an denen Ströme, Spannungen oder Temperaturen zu erfassen sind. Hierfür sind Schaltgeräte mit Stromerfassungsgeräten nach der Erfindung vorteilhaft in der Weise verwendbar, daß zusätzlich zu den den Stromerfassungsgeräten zugeordneten Bussystemen ein gemeinsamer lokaler Verbindungsbus zur Verbindung der einzelnen Bussysteme vorgesehen ist und daß an den Verbindungsbus eine zentrale Überwachungseinrichtung angeschlossen ist zur Anzeige der über die Bussysteme von den Mikroprozessorschaltungen übertragenen Ausgangswerte und zur wahlweisen Übertragung von Steuerbefehlen zur Veränderung von Parametern der Mikroprozessorschaltungen und/oder zur Vornahme von Schalthandlungen oder Verriegelungen. Damit hat eine Bedienungsperson nicht nur die Möglichkeit, sich einen raschen Überblick über den Betriebszustand einer Schaltanlage zu verschaffen, sondern kann darüberhinaus auch den Schaltzustand einzelner Schaltgeräte verändern oder deren Betätigung sperren.

Die Erfindung wird im folgenden anhand des in den Figuren dargestellten Ausführungsbeispieles näher erläutert.

Die Figur 1 zeigt in schematischer Darstellung eine Schaltanlage mit drei Leistungsschaltern, wobei einer der Leistungsschalter mit seinen prinzipiellen Bauteilen gezeigt ist.

Die Figur 2 zeigt im Schnitt ein Stromerfassungsgerät mit einem Kontaktelement für einen stromdurchflossenen Leiter.

In der Figur 3 ist schematisch eine mit Stromerfassungsgeräten ausgerüstete mehrfeldrige Schaltanlage gezeigt.

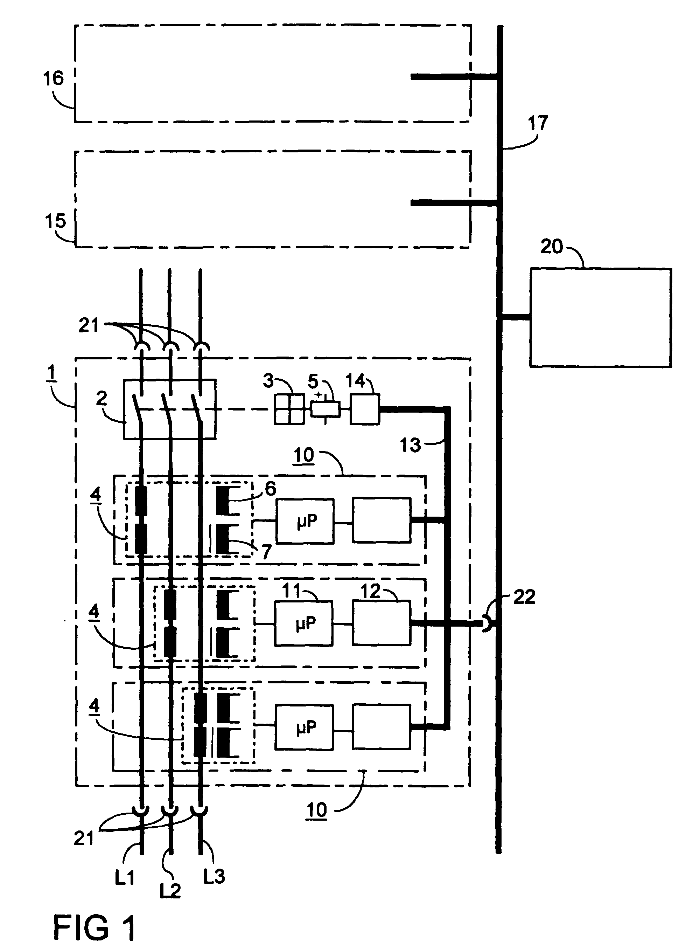

In der schematischen Darstellung gemäß der Figur 1 sind als Bestandteile eines Niederspannungs-Leistungsschalters 1 eine dreipolige Schaltkontaktanordnung 2 mit einem Schaltmechanismus 3 sowie Wandlerkombinationen 4 gezeigt. Der Schaltmechanismus 3 enthält in bekannter Weise eine Verklinkungseinrichtung 5, die zum Aufrechterhalten der geschlossenen Stellung der Schaltkontaktanordnung 2 dient und die mit geringer mechanischer Energie gelöst werden kann. Hierzu dient ein dem Schaltmechanismus 3 zugeordneter Auslösemagnet als Entklinkungseinrichtung 5.

Jede der Wandlerkombinationen 4 weist einen Stromsensor 6 und einen Hilfsenergiewandler 7 auf. Sowohl der Stromsensor als auch der Hilfsenergiewandler 7 können als konventionelle Stromwandler mit Eisenkern ausgebildet sein. Es ist jedoch auch möglich, den Stromsensor als Rogowski-Wandler auszubilden, wie dies an sich bekannt ist. Eine Wandlerkombination einer für die Zwecke der Erfindung geeigneten Art ist beispielsweise durch die DE 31 39 495 A1 bekannt geworden.

In der Figur 1 ist ferner angedeutet, daß jeweils eine Wandlerkombination 4 mit weiteren Baugruppen ein Stromerfassungsgerät 10 bildet. Dieses enthält neben der Wandlerkombination 4 eine Mikroprozessorschaltung 11 sowie eine Busschnittstelle 12. Die Busschnittstellen 12 der den Phasenleitern L1, L2 und L3 zugeordneten Stromerfassungsgeräte 10 sind durch ein gemeinsames Bussystem 13 verbunden, an das auch der Entklinkungseinrichtung 5 über eine eigene Schnittstelle 14 angeschlossen ist.

Die Mikroprozessorschaltung 11 in jedem der Stromerfassungsgeräte 10 verarbeitet die von den Stromsensoren abgegebenen Signale und übergibt diese der Busschnittstelle 12 zur Einspeisung in das Bussystem 13. Ferner vergleicht die Mikroprozessorschaltung 11 die ermittelten Meßwerte mit vorgegebenen Kennlinien und Parametern, die entsprechend der Schutzaufgabe des Leistungsschalters 1 ausgewählt bzw. eingestellt sind. Beim Überschreiten von Grenzwerten gibt die Mikroprozessorschaltung 11 gleichfalls ein zur Übertragung über das Bussystem 13 geeignetes Signal ab. Gelangt ein solches Auslösesignal über das Bussystem 13 zu der Schnittstelle 14 der Entklinkungseinrichtung 5, so wird der Schaltmechanismus 3 zur Auslösung der Schaltkontaktanordnung 2 freigegeben.

In der Figur 1 sind außer dem Leistungsschalter 1 zwei weitere Leistungsschalter 15 und 16 dargestellt, die den gleichen inneren Aufbau wie der Leistungsschalter 1 aufweisen können. Die drei gezeigten Leistungsschalter 1, 15 und 16 können sich in einem Feld einer Schaltanlage oder in benachbarten Feldern der Schaltanlage befinden. Ein zusätzlicher Verbindungsbus 17 ist mit dem Bussystem 13 verbunden und stellt auf diese Weise eine Verbindung zwischen den Leistungsschaltern 1, 15 und 16 hinsichtlich zwischen diesen auszutauschender Informationen her. Auf diese Weise sind über dem Verbindungsbus 17 beispielsweise alle über die Leistungsschalter 1, 15 und 16 fließenden Ströme sowie der jeweilige Status an zentraler Stelle erfaßbar. Ferner können die Auslöseparameter der Stromerfassungsgeräte 10 von einer zentralen Warte gesetzt werden. Eine solche Warte 20 ist in der Figur 1 gezeigt.

Leistungsschalter können in einer Schaltanlage sowohl fest eingebaut als auch einschiebbar angeordnet sein. In der Figur 1 ist der Leistungsschalter 1 als Einschubschalter mit Haupttrennkontakten 21 im Zuge der Phasenleiter L1, L2 und L3 dargestellt. Gleichfalls ist zur Verbindung des Bussystems 13 mit dem Verbindungsbus 17 eine Hilfstrennkontaktanordnung 22 vorgesehen. Die weiteren Leistungsschalter 15 und 16 können in gleicher Weise als Einschubschalter oder wahlweise als Festeinbauschalter ausgeführt sein. In diesem Fall wird der Anschluß des Verbindungsbusses 17 mit dem inneren Bussystem 13 der betreffenden Leistungsschalter über eine Steckverbindung hergestellt.

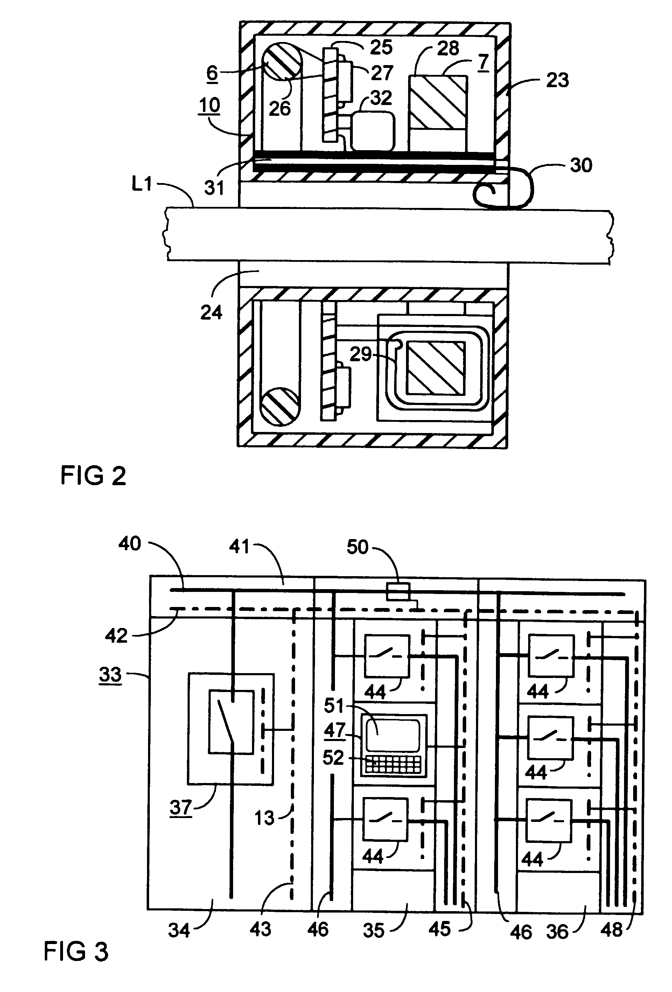

Den Aufbau eines Stromerfassungsgerätes 10 zeigt näher die Figur 2. Das beispielsweise dem Phasenleiter L1 zugeordnete Stromerfassungsgerät 10 weist ein Gehäuse 23 auf, das eine zentrale Öffnung 24 für den Durchtritt des Phasenleiters L1 aufweist. In dem Gehäuse 23 befindet sich eine Leiterplatte 25 als Träger einer Mikroprozessorschaltung 27.

Das Stromerfassungsgerät 10 ist ferner mit einem Kontaktelement 30 versehen, das vorzugsweise federnd ausgebildet ist und auf diese Weise bei der Anbringung des Stromerfassungsgerätes 10 an dem Phasenleiter L1 in leitende Verbindung mit diesem tritt. Das Kontaktelement 30 steht in Verbindung mit einem Kondensator 31, der gleichfalls in dem Gehäuse 23 untergebracht ist. Als Bestandteile des Kondensators sind schematisch zwei Elektrodenplatten gezeigt. Auf diese Weise ist die Spannung des Phasenleiters L1 gegenüber einem in geeigneter Weise zuzuführenden Bezugspotential meßbar. Die Mikroprozessorschaltung 27 übernimmt die Verarbeitung des Eingangsssignales von dem Kontaktelement 30 und gibt ein entsprechendes Spannungssignal ab. Da die Mikroprozessorschaltung 27 auch das von dem Stromsensor 26 abgegebene Stromsignal verarbeitet, können die Phasenverschiebung und die Leistung berechnet werden.

Bei geeigneter Ausbildung des Kontaktelementes 30 mit guter Wärmeleitfähigkeit wird die Temperatur des Phasenleiters in das Innere des Stromerfassungsgerätes 10 übertragen und wird dort einem Temperatursensor 32 zugeführt. Damit steht über das Bussystem 13 und den Verbindungsbus 17 (Figur 1) eine weitere wesentliche Kenngröße für den Betrieb einer Schaltanlage zur Verfügung. Insbesondere besteht die Möglichkeit, eine zu hohe Temperatur eines Phasenleiters im Bereich eines Leistungsschalters oder einer Sammelschiene als Kriterium für eine Auslösung auch dann heranzuziehen, wenn die übrigen Kennwerte dies nicht erfordern würden.

In dem Gehäuse 23 des Stromerfassungsgerätes 10 sind gemäß der Figur 2 auch der Stromsensor 6 und der Hilfsenergiewandler 7 untergebracht. Der Stromsensor 6 ist als Rogowski-Spule mit einem unmagnetischem Spulenkern 26 ausgebilet und befindet sich links der Leiterplatte 25. Der Hilfsenergiewandler 7 befindet sich auf der gegenüberliegenden Seite der Leiterplatte 25 und weist einen Eisenkern 28 mit einseitig angeordneter Wicklung 29 auf. Die zum Betrieb der Schaltungsanordnungen auf der Leiterplatte 25 benötigte Hilfsenergie wird somit direkt am Ort des Bedarfs bereitgestellt. Im Zusammenhang hiermit benötigte Schaltungsteile wie Gleichrichter, Kondensatoren, Drosseln usw. können gleichfalls auf der Leiterplatte untergebracht sein.

Ein Beispiel für die Verknüpfung von Schaltgeräten mit Stromerfassungsgeräten zeigt die Figur 3.

In der Figur 3 ist schematisch eine Schaltanlage 33 dargestellt, die aus drei Feldern 34, 35 und 36 besteht. Das links gezeigte Feld 34 enthält einen Leistungsschalter 37, der einen Aufbau entsprechend dem Leistungsschalter 1 in Figur 1 aufweisen kann und der ein Bussystem 13 enthält. Der Leistungsschalter 37 dient als Einspeiseschalter, der die beispielsweise aus einem Kabel zugeführte Energie auf ein Sammelschienensystem 40 leitet. Das Sammelschienensystem 40 befindet sich in einem Sammelschienenraum 41, der sich über die drei benachbarten Felder 34, 35 und 36 erstreckt. Gleichfalls enthält der Sammelschienenraum 41 einen lokalen Verbindungsbus 42, der über einen Abzweig 43 mit dem Bussystem 13 des Leistungsschalters 37 in Verbindung steht.

Das mittlere Feld 35 der Schaltanlage 33 weist drei übereinander angeordnete Schaltzellen auf, von denen die untere und die obere mit je einem Schaltgeräteeinschub 44 bestückt sind. Diese weisen gleichfalls je ein Bussystem 13 auf, das mit einem weiteren Abzweig 45 des Verbindungsbusses 42 in Verbindung stehen. Die mittlere Schaltzelle des Feldes 35 ist mit einem Leitgerät 47 bestückt, auf das noch näher eingegangen wird.

Die Energiezuführung zu den Schaltgeräteeinschüben 44 des Feldes 35 erfolgt über eine Feldschiene 46, die sich vertikal an der linken Seite des Feldes 35 erstreckt. An der rechten Seite des Feldes befindet sich gleichfalls ein Schacht für abgehende Energieleitungen sowie für den Abzweig 45 des Verbindungsbusses 42. Sinngemäß den gleichen Aufbau besitzt das rechte Feld 36, das gleichfalls an der linken Seite einen Raum für eine Feldschiene 46 und rechts einen Raum für Abgänge und einen Abzweig 48 des Verbindungsbusses 42 besitzt. Ferner enthält das rechte Feld 36 in drei übereinander befindlichen Schaltzellen Schaltgeräteeinschübe 44.

Jedes der in der Figur 3 gezeigten Schaltgeräte, d. h. der Leistungsschalter 37 sowie die Schaltgeräteeinschübe 44, enthalten Stromerfassungsgeräte, wie sie anhand der Figur 2 erläutert wurden. Bei mehrpoliger Ausbildung der Schaltgeräte ist dabei jeder Pol mit einem Stromerfassungsgerät versehen, ggfs. auch der Neutralleiter des Netzes. Während diese Stromerfassungsgeräte in der Figur 3 nicht gesondert gezeigt sind, ist im Zuge der Sammelschiene 40 ein Stromerfassungsgerät 50 dargestellt, das direkt an den lokalen Verbindungsbus 42 angeschlossen ist. Das zentrale Leitgerät 47 in dem mittleren Feld 35 weist einen Bildschirm 51 sowie eine Tastatur 52 auf.

Durch Adressierung der Schaltgeräte mittels der Tastatur sind auf dem Bildschirm 51 die von den Stromerfassungsgeräten der Schaltgeräte und von dem Stromerfassungsgerät 50 an der Sammelschiene 40 übermittelten Meßwerte und sonstige Parameter darstellbar. Beispielsweise kann auf dem Bildschirm 51 angezeigt werden, daß der Leistungsschalter 37 aufgrund einer Überlastung ausgelöst wurde und nach welcher Zeit bei welchem Strom dies geschah. Ferner kann zur Anzeige gebracht werden, welche Temperatur in dem Leistungsschalter 37 herrscht und ob dieser wieder eingeschaltet werden kann. Gleichartige Angaben sind zu jedem der Schaltgeräteeinschübe 44 erhältlich. In der Gegenrichtung sind mittels der Tastatur 52 Steuerbefehle zu den Schaltgeräten übertragbar. Beispielsweise kann der Leistungsschalter 37 ferngesteuert ein- und ausgeschaltet werden. Ebenso sind die Schaltgeräteeinschübe 44 steuerbar. Auf die gleiche Weise können Grenzwerte für eine selbsttätige Auslösung oder andere Parameter gesetzt werden.

## Patentansprüche

1. Schaltgerät mit einem Stromerfassungsgerät (10) zur Anbringung an einem stromdurchflossenen Leiter (L1, L2, L3), mit einem Stromsensor (6, 26) und einer eine Ausgangsgröße des Stromsensors (6, 26) verarbeitenden Schaltungsanordnung sowie mit einer die Schaltungsanordnung tragenden Leiterplatte (25) und mit einem die Leiterplatte aufnehmenden Gehäuse (23), das eine Öffnung (24) für den Durchtritt des Leiters (L1, L2, L3) besitzt, wobei die Schaltungsanordnung eine Mikroprozessorschaltung (27) zur Bereitstellung durch Vergleich gemessener Stromwerte mit vorgegebenen Parametern ermittelter Ausgangswerte sowie eine Schalteinrichtung zur Abgabe eines Auslösesignales für das Schaltgerät (1, 15, 16, 37, 44) besitzt,
**dadurch gekennzeichnet,** daß bei einem mehrpoligen Schaltgerät (1, 15, 16, 37, 44) jedem der Pole ein Stromerfassungsgerät (10) zugeordnet ist und daß das Stromerfassungsgerät eine Busschnittstelle (12) zur Übertragung der Auslösesignale in einem zugehörigen Bussystem (13, 17) aufweist, wobei das Bussystem (13, 17) das Stromerfassungsgerät (10) und einen Schaltmechanismus (3) des Schaltgerätes (1, 15, 16, 37, 44) miteinander verbindet.

2. Schaltgerät nach Anspruch 1,
**dadurch gekennzeichnet,** daß im Bereich der Öffnung (24) des Gehäuses (13) des Stromerfassungsgerätes (10) ein Kontaktelement (30) mit dem Leiter (L1, L2, L3) elektrisch verbunden ist, und daß auf der Leiterplatte (25) eine Schaltungsanordnung zur Messung der Spannung des Leiters (L1, L2, L3) angeordnet ist.

3. Schaltgerät nach Anspruch 2,
**dadurch gekennzeichnet**, daß das Kontaktelement (30) des Stromerfassungsgerätes (10) gut wärmeleitend ausgebildet ist und mit einem Temperatursensor (32) in Verbindung steht.

4. Unter Verwendung von Schaltgeräten (37, 44) nach einem der vorangehenden Ansprüche aufgebaute Schaltanlage (33) mit mehreren Meßstellen,
**dadurch gekennzeichnet,** daß zusätzlich zu den den Stromerfassungsgeräten (10) zugeordneten Bussystemen (13) ein die Bussysteme (13) verbindender gemeinsamer lokaler Verbindungsbus (42) vorgesehen ist und an den Verbindungsbus (42) eine zentrale Überwachungseinrichtung (47) angeschlossen ist zur Anzeige der über die Bussysteme (13) übertragenen Ausgangswerte der Mikroprozessorschaltungen und zur wahlweisen Übertragung von Steuerbefehlen zur Veränderung von Parametern der Mikroprozessorschaltungen und/oder zur Vornahme von Schalthandlungen oder Verriegelungen.

## Claims

1. Switching device having a current detecting device (10) for mounting on a current-carrying conductor (L1, L2, L3), having a current sensor (6, 26) and a circuit arrangement that processes an output quantity of the current sensor (6, 26), and also having a printed circuit board (25), which carries the circuit arrangement, and having a housing (23), which accommodates the printed circuit board and has an opening (24) for the passage of the conductor (L1, L2, L3), the circuit arrangement having a microprocessor circuit (27) for producing output values that are determined by the comparison of measured current values with predetermined parameters, and also a switching unit for outputting a release signal for the switching device (1, 15, 16, 37, 44),
characterized in that in the case of a multipole switching device (1, 15, 16, 37, 44), each of the poles is assigned a current detecting device (10), and in that the current detecting device has a bus interface (12) for transmitting the release signals in an associated bus system (13, 17), the bus system (13, 17) connecting the current detecting device (10) and a switching mechanism (3) of the switching device (1, 15, 16, 37, 44) to one another.

2. Switching device according to claim 1,
characterized in that a contact element (30) is electrically connected to the conductor (L1, L2, L3) in the region of the opening (24) in the housing (13) of the current detecting device (10), and in that a circuit arrangement for measuring the voltage of the conductor (L1, L2, L3) is arranged on the printed circuit board (25).

3. Switching device according to claim 2,
characterized in that the contact element (30) of the current detecting device (10) is designed to have good thermal conductivity and is connected to a temperature sensor (32).

4. Switching installation (33) constructed using switching devices (37, 44) according to one of the preceding claims and having a plurality of measurement points,
characterized in that in addition to the bus systems (13) assigned to the current detecting devices (10), a common local connection bus (42) connecting the bus systems (13) is provided and a central monitoring unit (47) is connected to the connection bus (42), for displaying the output values of the microprocessor circuits that have been transmitted via the bus systems (13), and for optionally transmitting control commands for altering parameters of the microprocessor circuits and/or for performing switching operations or latching operations.

## Revendications

1. Appareil de distribution avec un dispositif de détection de courant (10) qui est destiné à être monté sur un conducteur (L1, L2, L3) dans lequel passe un courant et qui comporte un capteur de courant (6, 26) et un circuit traitant une grandeur de sortie du capteur de courant (6, 26) ainsi qu'une carte imprimée (25) portant le circuit et un boîtier (23) qui loge la carte imprimée et qui a une ouverture (24) pour le passage du conducteur (L1, L2, L3), le circuit ayant un circuit à microprocesseur (27) pour préparer des valeurs de sortie déterminées par une comparaison de valeurs de courant mesurées à des paramètres prescrits ainsi qu'un dispositif de commutation pour envoyer un signal de déclenchement destiné à l'appareil de distribution (1, 15, 16, 37, 44),
caractérisé par le fait que, dans le cas d'un appareil de distribution multipolaire (1, 15, 16, 37, 44), un dispositif de détection de courant (10) est associé à chacun des pôles et que le dispositif de détection de courant comporte une interface de bus (12) pour la transmission des signaux de déclenchement dans un système de bus associé (13, 17), le système de bus (13, 17) reliant alors le dispositif de détection de courant (10) et un mécanisme de manoeuvre (3) de l'appareil de distribution (1, 15, 16, 37, 44).

2. Appareil de distribution selon la revendication 1,
caractérisé par le fait que, dans la zone de l'ouverture (24) du boîtier (23) du dispositif de détection de courant (10), un élément de contact (30) est relié électriquement au conducteur (Ll, L2, L3) et qu'un circuit pour la mesure de la tension du conducteur (L1, L2, L3) est prévu sur la carte imprimée (25).

3. Appareil de distribution selon la revendication 2,
caractérisé par le fait que l'élément de contact (30) du dispositif de détection de courant (10) est conçu comme un bon conducteur de chaleur et est en liaison avec un capteur de température (32).

4. Installation de distribution (33) conçue en utilisant des appareils de distribution (37, 44) selon l'une des revendications précédentes et comportant plusieurs endroits de mesure,
caractérisée par le fait que, en plus des systèmes de bus (13) associés aux dispositifs de détection de courant (10), il est prévu un bus de liaison (42) local commun reliant les systèmes de bus (13) et qu'un dispositif de contrôle central (47) est raccordé au bus de liaison (42) en vue de l'affichage des valeurs de sortie transmises par les circuits à microprocesseurs par l'intermédiaire des systèmes de bus (13) et en vue de la transmission optionnelle d'instructions de commande destinées à modifier des paramètres des circuits à microprocesseurs et/ou à effectuer des manoeuvres de coupure ou des verrouillages.
